# EUROPEAN PATENT APPLICATION

(11) **EP 2 398 051 A2**
(43) Date of publication of application: **21.12.2011**
(21) Application number: 10181747.6
(22) Date of filing: 29.09.2010
(51) Int. Cl.: H01L 25/075

(54) **LED package structure**

(30) Priority: 26.05.2010 TW 099116913
(71) Applicant: Intematix Technology Center Corporation, Taoyuang County (TW)
(72) Inventor: Cheng, Tzu-Chi, Taoyuan City Chinese Taipei (TW)
(74) Representative: Viering, Jentschura & Partner

(57) **Abstract**

A light-emitting diode (LED) package structure includes a substrate (110), a first LED (120), a second LED (130), and a resin material (140). At least one enclosure (111) made of a transparent material formed on a surface of the substrate, and encloses and forms at least one area (112) on the substrate. The first LED and the second LED are disposed in the area and adjacent to each other, and the resin material is disposed in the area, and covers the first LED and the second LED. The LED package structure obtains desired illuminating lights by mixing lights respectively emitted by the first LED and the second LED.

## Description

### BACKGROUND OF THE INVENTION

### Field of the Invention

The present invention relates to a package structure, and more particularly to a light-emitting diode (LED) package structure having LEDs disposed in an enclosure.

### Related Art

Thanks to the advantages of low power consumption, high efficiency, and long service life, LEDs are widely applied in various fields, for example, light sources of backlight modules used in notebook computers, monitoring camera, mobile phones, televisions, and liquid crystal displays. Moreover, as more and more researchers are engaged in the research and development of LEDs, the luminous intensity of LEDs has currently met the illumination requirements.

A currently commonly used white LED is taken as an example. For example, as disclosed in Taiwan Patent No. I291251, Taiwan Patent No. 200905854, Taiwan Patent No. I237406, and Taiwan Patent No. I253192, a white LED is based on combinations of light of three primary colors. Particularly, three types of LED chips emitting red, green, and blue light are combined in the form of an array and packaged, and the color light emitted by the LEDs of three different colors is mixed, thereby obtaining a multi-chip LED package device capable of emitting white light.

However, the conventional white LED package device cannot provide a light source with uniform luminous intensity and color tone, which seriously affects the luminous quality. When the conventional white LED package device is used as a light source for illumination, no technical means for adjusting the correlated color temperature (CCT) of the white LED is provided.

Since the basic light-emitting unit of the conventional white LED is a combination of three chips, the manufacturing cost of the chips is rather high, and the three chips operate at the same time, which results in high power consumption and heat generation. Moreover, three groups of circuits are required to respectively control the luminous quantities of the three chips in the above LED package structure design, so that the LED driving circuit has a complex design.

### SUMMARY OF THE INVENTION

In view of the above problems, the present invention is an LED package structure, applicable to solve the problems that the conventional LED package device has non-uniform color temperature and the LED driving circuit has a complex design.

An LED package structure of the present invention comprises a substrate, a first LED, a second LED, and a resin material. An enclosure is disposed on a surface of the substrate, and encloses and forms an area on the substrate. A material of the enclosure is a transparent material. The first LED and the second LED are disposed in the area and adjacent to each other. The first LED emits a first light with a first wavelength. The second LED emits a second light with a second wavelength. The second light is mixed with the first light to obtain an illuminating light. The resin material is disposed in the area, and covers the first LED and the second LED.

Another LED package structure of the present invention comprises a substrate, at least one first LED, at least one second LED, and a resin material. The substrate has an enclosure and a partition wall disposed on a surface thereof. The partition wall is disposed in the enclosure, so as to enclose and forms two areas on the substrate. A material of the enclosure is a transparent material. The first LED is disposed in one of the areas, and emits a first light with a first wavelength. The second LED is disposed in the other area, and emits a second light with a second wavelength. The second light is mixed with the first light to obtain an illuminating light. The resin material is disposed in the two areas, and covers the first LED and the second LED.

Still another LED package structure of the present invention comprises a substrate, at least one first LED, at least one second LED, and a resin material. The substrate has two neighboring enclosures disposed on a surface thereof. The two enclosures respectively enclose and form two areas on the substrate. A material of the two enclosures is a transparent material. The first LED is disposed in one of the areas, and emits a first light with a first wavelength. The second LED is disposed in the other area, and emits a second light with a second wavelength. The second light is mixed with the first light to obtain an illuminating light. The resin material is disposed in the two areas, and covers the first LED and the second LED.

The efficacy of the present invention is that, an illuminating light of a desired light color can be obtained by mixing the two lights emitted by the first LED and the second LED disposed in the area formed by the enclosure. In addition, in the present invention, by using the light-transmissive enclosure to enclose the LEDs, the package structure is quite simple, so that the manufacturing steps can be greatly simplified and the manufacturing cost can be dramatically reduced, and meanwhile the overall luminous efficiency of the LED package structure can be improved.

### BRIEF DESCRIPTION OF THE DRAWINGS

The present invention will become more fully understood from the detailed description given herein below for illustration only, and thus is not limitative of the present invention, and wherein:
FIG. 1A is a cross-sectional side view of a first embodiment of the present invention;
FIG. 1B is a cross-sectional side view of a different aspect of the first embodiment of the present invention;
FIG. 1C is a cross-sectional side view of a different aspect of the first embodiment of the present invention;
FIG. 1D is a cross-sectional side view of a different aspect of the first embodiment of the present invention;
FIG. 1E is a cross-sectional side view of a different aspect of the first embodiment of the present invention;
FIG. 2A is a cross-sectional side view of a second embodiment of the present invention;
FIG. 2B is a cross-sectional side view of a different aspect of the second embodiment of the present invention;
FIG. 2C is a cross-sectional side view of a different aspect of the second embodiment of the present invention;
FIG. 2D is a cross-sectional side view of a different aspect of the second embodiment of the present invention;
FIG. 2E is a cross-sectional side view of a different aspect of the second embodiment of the present invention;
FIG. 3A is a cross-sectional side view of a third embodiment of the present invention;
FIG. 3B is a cross-sectional side view of a different aspect of the third embodiment of the present invention;
FIG. 3C is a cross-sectional side view of a different aspect of the third embodiment of the present invention;
FIG. 3D is a cross-sectional side view of a different aspect of the third embodiment of the present invention; and
FIG. 3E is a cross-sectional side view of a different aspect of the third embodiment of the present invention.

### DETAILED DESCRIPTION OF THE INVENTION

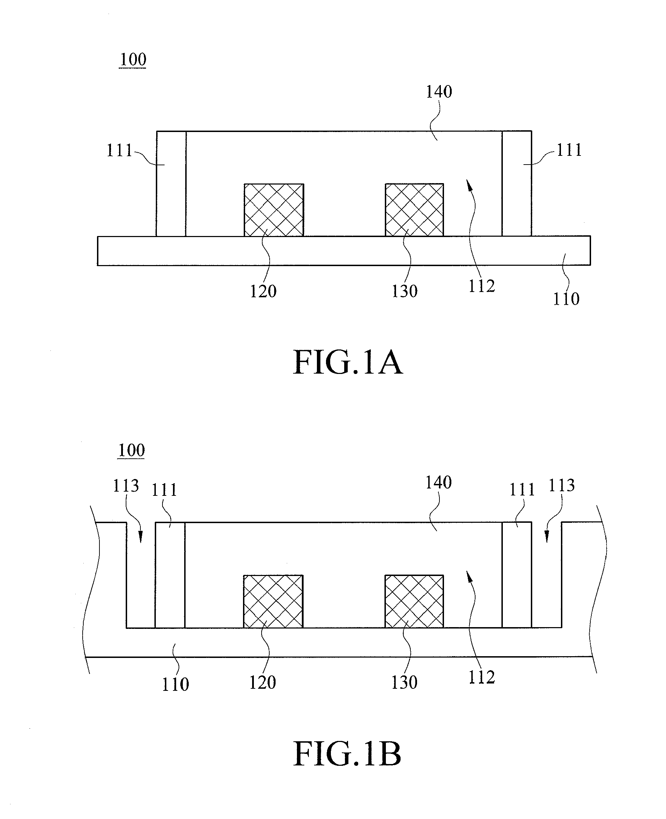

FIG. 1A is a cross-sectional side view of a first embodiment of the present invention. As shown in FIG. 1A, an LED package structure 100 according to the first embodiment of the present invention comprises a substrate 110, a first LED 120, a second LED 130, and a resin material 140. A material of the substrate 110 is selected from a group consisting of, but not limited to, a metal material, a ceramic material, a diamond material, a diamond-like carbon material, and a printed circuit board. An enclosure 111 forms on a top surface of the substrate 110, and encloses and forms an area 112 on the surface of the substrate 110.

It should be noted that, a material of the enclosure 111 of the present invention is a transparent material, and the area 112 formed by the enclosure 111 in this embodiment has a circular shape, a rectangle shape, or an ellipse shape. However, persons skilled in the art may design the area 112 into various geometrical shapes according to practical application requirements.

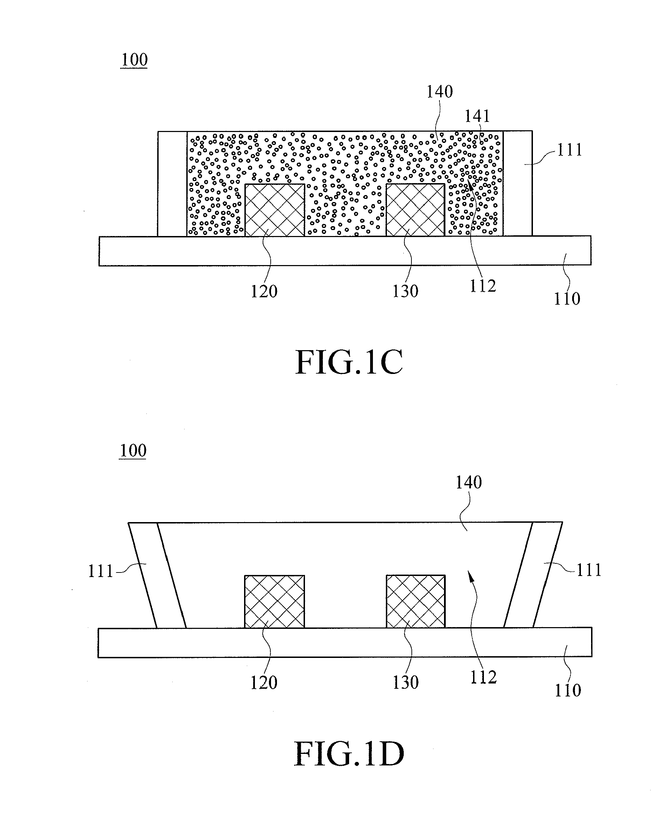

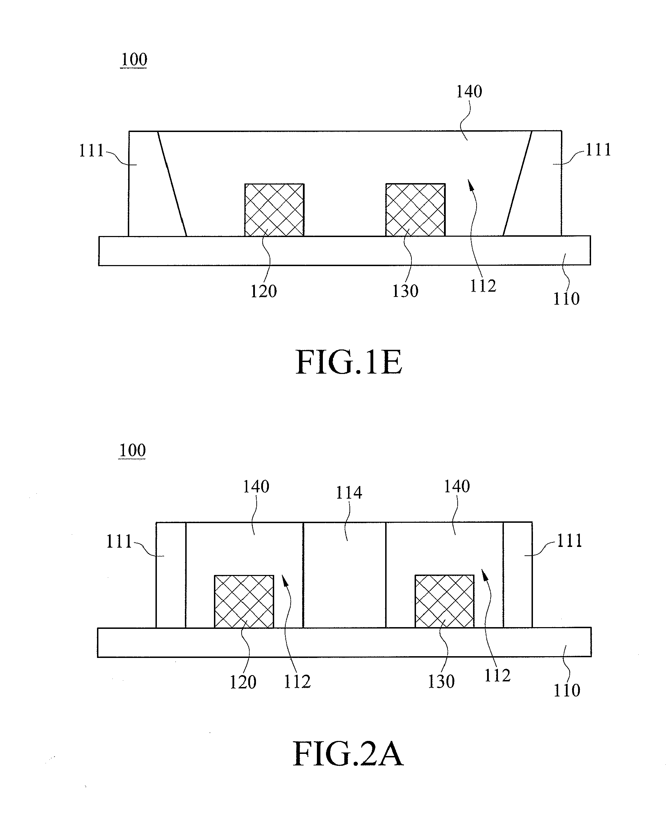

In addition, the enclosure 111 of the first embodiment shown in FIG. 1A has a rectangular plate-like structure, and the enclosure 111 is perpendicular to the substrate 110. However, the enclosure 111 of the present invention may also be designed as being disposed on the substrate 110 at an angle of inclination as shown in FIG. 1D, or designed into a trapezoid-like structure as shown in FIG. 1E, which both aim at optimizing light reflection. Therefore, persons skilled in the art may further derive and design various geometrical shapes and different placement angles for the enclosure 111 of the present invention according to practical application requirements, which are not limited to the embodiments of the present invention.

Still referring to FIG. 1A, both the first LED 120 and the second LED 130 are disposed in the area 112, that is, the two LEDs 120 and 130 are located in the enclosure 111. The first LED 120 and the second LED 130 are electrically connected to a voltage respectively, and the first LED 120 and the second LED 130 are driven by the voltage to respectively emit a first light with a first wavelength and a second light with a second wavelength.

It should be noted that, a wavelength range of the first wavelength of the first LED 120 may be identical to a wavelength range of the second wavelength of the second LED 130, that is, the lights emitted by the first LED 120 and the second LED 130 are of the same color. Therefore, an illuminating light obtained by mixing the first light with the second light is of the same color as the first light and the second light, for example, various light colors such as cold white light, warm white light, and sunlight-like white light are obtained. The illuminating light has high color rendering properties. The lights emitted by the two LEDs 120 and 130 may be short-wavelength light with a wavelength range of 360 nm to 550 nm, or may be long-wavelength light with a wavelength range of 580 nm to 640 nm. Alternatively, the wavelength range of the first wavelength of the first LED 120 may be different from the wavelength range of the second wavelength of the second LED 130, that is, the lights emitted by the first LED 120 and the second LED 130 are of different colors. Therefore, the illuminating light obtained by mixing the first light with the second light is of a color corresponding to the actual colors of the first light and the second light, for example, various light colors such as cold white light, warm white light, and sunlight-like white light are obtained. The illuminating light has high color rendering properties. The light emitted by one of the LEDs 120 and 130 may be short-wavelength light with a wavelength range of 360 nm to 550 nm, and the light emitted by the other one of the LEDs 120 and 130 may be long-wavelength light with a wavelength range of 580 nm to 640 nm. The illuminating light of the present invention has a total reflection effect of vertical and horizontal reflection by using the enclosure 111, thereby avoiding excessively high light loss of the illuminating light in the refraction process.

A material of the resin material 140 of the present invention may be, but not limited to, a polymer material such as epoxy resin or silicone. The resin material 140 is filled in the area 112, and completely covers the first LED 120 and the second LED 130, thereby forming a complete LED package structure 100.

FIG. 1B is a cross-sectional side view of a different aspect of the first embodiment of the present invention. As shown in FIG. 1B, the LED package structure 100 comprises a substrate 110, a first LED 120, a second LED 130, and a resin material 140. The substrate 110 further has a groove 113 recessed therein. An enclosure 11 1 made of a transparent material is disposed in the groove 113. The first LED 120 and the second LED 130 are disposed in the enclosure 111, so that the first LED 120 and the second LED 130 are also electrically disposed in the groove 113. The resin material 140 is filled in the area 112, and completely covers the first LED 120 and the second LED 130, thereby forming a complete LED package structure 100. When an illuminating light is reflected to a wall surface of the groove 113, the groove 113 provides a preferable light reflection effect.

FIG. 1C is a cross-sectional side view of a different aspect of the first embodiment of the present invention. As shown in FIG. 1C, the LED package structure 100 comprises a substrate 110, a first LED 120, a second LED 130, and a resin material 140. An enclosure 111 forms on a top surface of the substrate 110, and encloses and forms an area 112 on the surface of the substrate 110, and the enclosure 111 is made of a transparent material. Both the first LED 120 and the second LED 130 are disposed in the area 112, that is, the two LEDs 120 and 130 are located in the enclosure 111. The first LED 120 and the second LED 130 are driven by a voltage to respectively emit a first light with a first wavelength and a second light with a second wavelength.

The resin material 140 is filled in the area 112, and completely covers the first LED 120 and the second LED 130, thereby forming a complete LED package structure 100. The resin material 140 may further contain a fluorescent material 141 in a powder form. The fluorescent material 141 is selected from a group consisting of Sr_{1-x-y}BaₓCa_{y}SiO₄:Eu₂₊F, (Sr_{l-x-y}EuₓMn_{y})P_{2+z}O₇ :Eu₂₊F, (Ba,Sr,Ca)Al₂O₄:Eu, ((Ba,Sr,Ca)(Mg,Zn))Si₂O₇:Eu, SrGa₂S₄:Eu, ((Ba,Sr,Ca)₁₋ₓEuₓ)(Mg,Zn)₁₋ₓMnₓ))Al₁₀O₁₇, CagMg(SiO₄)₄Cl₂:Eu,Mn, ((Ba,Sr,Ca,Mg)₁₋ₓEuₓ)₂SiO₄, Ca₂MgSi₂O₇:Cl, SrSi₃O₈·2SrCl₂:Eu, BAM:Eu, Sr-Aluminate:Eu, Thiogallate:Eu, Chlorosilicate:Eu, Borate:Ce,Tb, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, (Sr,Ca,Ba,Mg)₁₀(PO₄)₆Cl₂:Eu ZnS:Cu,AI, (Y,Gd,Tb,Lu,Yb)(Al_{y}Ga_{1-y})₅O₁₂:Ce, (Sr_{1-x-y-z}BaₓCa_{y}EU_{z})₂SiO₄, (Sr_{1-a-b}Ca_{b}Ba_{c})SiₓNyO_{z}:Euₐ Srs(PO₄);Cl:Euₐ, and any combination thereof. However, the fluorescent material 141 is not limited to the above materials, and the form of the fluorescent material 141 is not limited to the powder form disclosed in this embodiment as well, and persons skilled in the art may add the fluorescent material 141 into the resin material 140 in various forms according to practical fabrication requirements, for example, adhere the fluorescent material 141 to a top surface of the resin material 140 in a colloid form. When an illuminating light passes through the resin material 140, the fluorescent material 141 mixed in the resin material 140 provides a preferable reflection effect for the illuminating light.

FIG. 2A is a cross-sectional side view of a second embodiment of the present invention. As shown in FIG. 2A, an LED package structure 100 according to the second embodiment of the present invention comprises a substrate 110, at least one first LED 120, at least one second LED 130, and a resin material 140. A material of the substrate 110 is selected from a group consisting of, but not limited to, a metal material, a ceramic material, a diamond material, a diamond-like carbon material, and a printed circuit board. The substrate 110 has an enclosure 111 and a partition wall 114 forming on a top surface thereof. The enclosure 111 encloses and forms an area on the surface of the substrate 110. The partition wall 114 and the enclosure 111 approximately have the same height. The partition wall 114 is disposed in the enclosure 111, so as to further divide the area into two adjacent areas 112. A material of the enclosure 111 of the present invention is a transparent material, a material of the partition wall 114 may be a transparent material or an opaque material, and persons skilled in the art may design the areas 112 into various geometrical shapes according to practical application requirements.

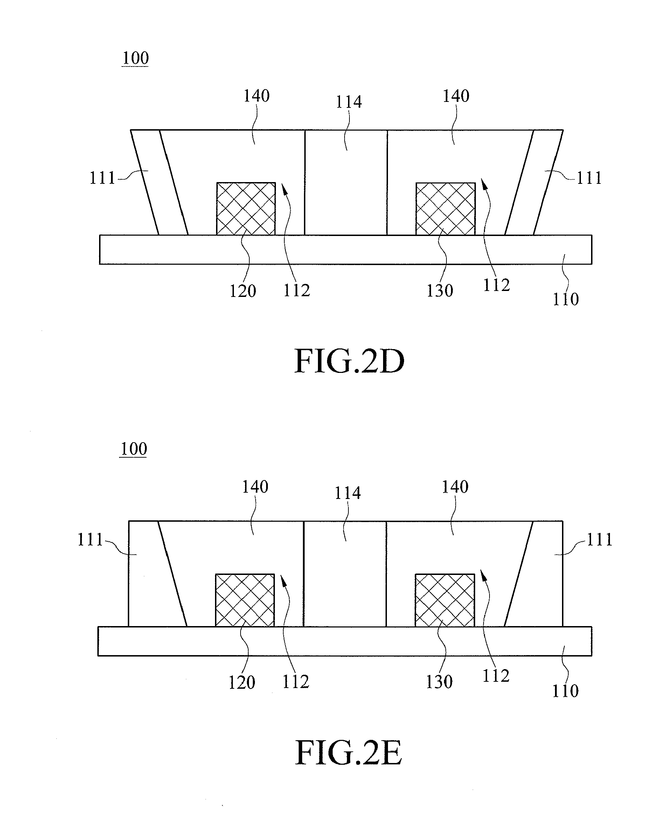

In addition, the enclosure 111 of the second embodiment shown in FIG. 2A has a rectangular plate-like structure, and the enclosure 111 is perpendicular to the substrate 110. However, the enclosure 111 of the present invention may also be designed as being disposed on the substrate 110 at an angle of inclination as shown in FIG. 2D, or designed into a trapezoid-like structure as shown in FIG. 2E, which both aim at optimizing light reflection. Therefore, persons skilled in the art may further derive and design various geometrical shapes and different placement angles for the enclosure 111 of the present invention according to practical application requirements, which are not limited to the embodiments of the present invention.

Still referring to FIG. 2A, the first LED 120 is disposed in one of the areas 112, and the second LED 130 is disposed in the other area 112, that is, the two LEDs 120 and 130 are located in the enclosure 111. The first LED 120 and the second LED 130 are electrically connected to a voltage respectively, and the first LED 120 and the second LED 130 are driven by the voltage to respectively emit a first light with a first wavelength and a second light with a second wavelength.

It should be noted that, a wavelength range of the first wavelength of the first LED 120 may be identical to a wavelength range of the second wavelength of the second LED 130, that is, the lights emitted by the first LED 120 and the second LED 130 are of the same color. Therefore, an illuminating light obtained by mixing the first light with the second light is of the same color as the first light and the second light, for example, various light colors such as cold white light, warm white light, and sunlight-like white light are obtained. The illuminating light has high color rendering properties. The lights emitted by the two LEDs 120 and 130 may be short-wavelength light with a wavelength range of 360 nm to 550 nm, or may be long-wavelength light with a wavelength range of 580 nm to 640 nm. Alternatively, the wavelength range of the first wavelength of the first LED 120 may be different from the wavelength range of the second wavelength of the second LED 130, that is, the lights emitted by the first LED 120 and the second LED 130 are of different colors. Therefore, the illuminating light obtained by mixing the first light with the second light is of a color corresponding to the actual colors of the first light and the second light, for example, various light colors such as cold white light, warm white light, and sunlight-like white light are obtained. The illuminating light has high color rendering properties. The light emitted by one of the LEDs 120 and 130 may be short-wavelength light with a wavelength range of 360 nm to 550 nm, and the light emitted by the other one of the LEDs 120 and 130 may be long-wavelength light with a wavelength range of 580 nm to 640 nm. The illuminating light of the present invention has a total reflection effect of vertical and horizontal reflection by using the enclosure 111, thereby avoiding excessively high light loss of the illuminating light in the refraction process.

The number of the first LED 120 and the second LED 130 arranged in this embodiment may be increased or decreased according to practical application requirements, as long as the LEDs in the same area 112 have the same wavelength range.

A material of the resin material 140 of the present invention may be, but not limited to, a polymer material such as epoxy resin or silicone. The resin material 140 is filled in the two areas 112, and completely covers the first LED 120 and the second LED 130, thereby forming a complete LED package structure 100.

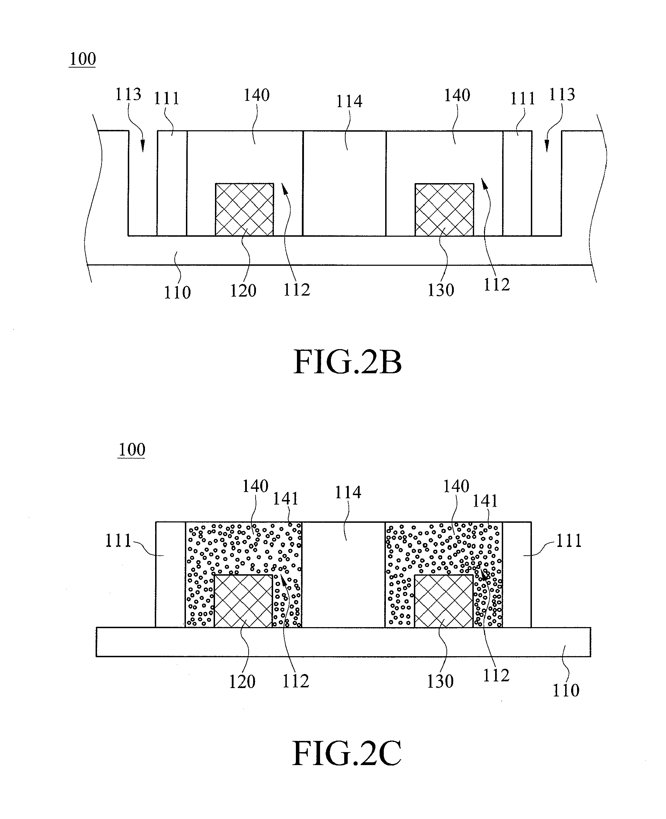

FIG. 2B is a cross-sectional side view of a different aspect of the second embodiment of the present invention. As shown in FIG. 2B, the LED package structure 100 comprises a substrate 110, at least one first LED 120, at least one second LED 130, and a resin material 140. The substrate 110 further has a groove 113 recessed therein. An enclosure 111 and a partition wall 114 are disposed in the groove 113. The first LED 120 and the second LED 130 are disposed in the enclosure 111, so that the first LED 120 and the second LED 130 are also electrically disposed in the groove 113. The resin material 140 is filled in the two areas 112, and completely covers the first LED 120 and the second LED 130, thereby forming a complete LED package structure 100. When an illuminating light is reflected to a wall surface of the groove 113, the groove 113 provides a preferable light reflection effect.

FIG. 2C is a cross-sectional side view of a different aspect of the second embodiment of the present invention. As shown in FIG. 2C, the LED package structure 100 comprises a substrate 110, at least one first LED 120, at least one second LED 130, and a resin material 140. An enclosure 111 and a partition wall 114 form on a top surface of the substrate 110, and enclose and form two areas 112 on the surface of the substrate 110. The enclosure 111 is made of a transparent material. The first LED 120 and the second LED 130 are respectively disposed in the two areas 112, that is, the two LEDs 120 and 130 are located in the enclosure 111. The first LED 120 and the second LED 130 are driven by a voltage to respectively emit a first light with a first wavelength and a second light with a second wavelength.

The resin material 140 is filled in the two areas 112, and completely covers the first LED 120 and the second LED 130, thereby forming a complete LED package structure 100. The resin material 140 may further contain a fluorescent material 141 in a powder form. The fluorescent material 141 is selected from a group consisting of Sr_{1-x-y}BaₓCa_{y}SiO₄:Eu₂₊F, (Sr_{1-x-y}EuₓMn_{y})P_{2+z}O₇ :Eu₂₊F, (Ba,Sr,Ca)Al₂O₄:Eu, ((Ba,Sr,Ca)(Mg,Zn))Si₂O₇:Eu, SrGa₂S₄:Eu, ((Ba,Sr,Ca)₁₋ₓEuₓ)(Mg,Zn)₁₋ₓMnₓ))Al₁₀O₁₇, Ca₈Mg(SiO₄)₄Cl₂:Eu,Mn, ((Ba,Sr,Ca,Mg)₁₋ₓEuₓ)₂SiO₄, Ca₂MgSi₂O₇:Cl, SrSi₃O₈·2SrCl₂:Eu, BAM:Eu, Sr-Aluminate:Eu, Thiogallate:Eu, Chlorosilicate:Eu, Borate:Ce,Tb, Sr₄Al₄O₂₅:Eu, YB0₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, (Sr,Ca,Ba,Mg)₁₀(PO₄)₆Cl₂:Eu ZnS:Cu,Al, (Y,Gd,Tb,Lu,Yb)(AlyGa_{1-y})₅O₁₂:Ce, (Sr_{1-x-y-z}BaₓCa_{y}Eu_{z})₂SiO₄, (Sr_{1-a-b}Ca_{b}Ba_{c})SiₓN_{y}O_{z}:Euₐ Sr₅(PO₄)₃Cl:Euₐ, and any combination thereof. However, the fluorescent material 141 is not limited to the above materials, and the form of the fluorescent material 141 is not limited to the powder form disclosed in this embodiment as well, and persons skilled in the art may add the fluorescent material 141 into the resin material 140 in various forms according to practical fabrication requirements, for example, adhere the fluorescent material 141 to a top surface of the resin material 140 in a colloid form. When an illuminating light passes through the resin material 140, the fluorescent material 141 mixed in the resin material 140 provides a preferable reflection effect for the illuminating light.

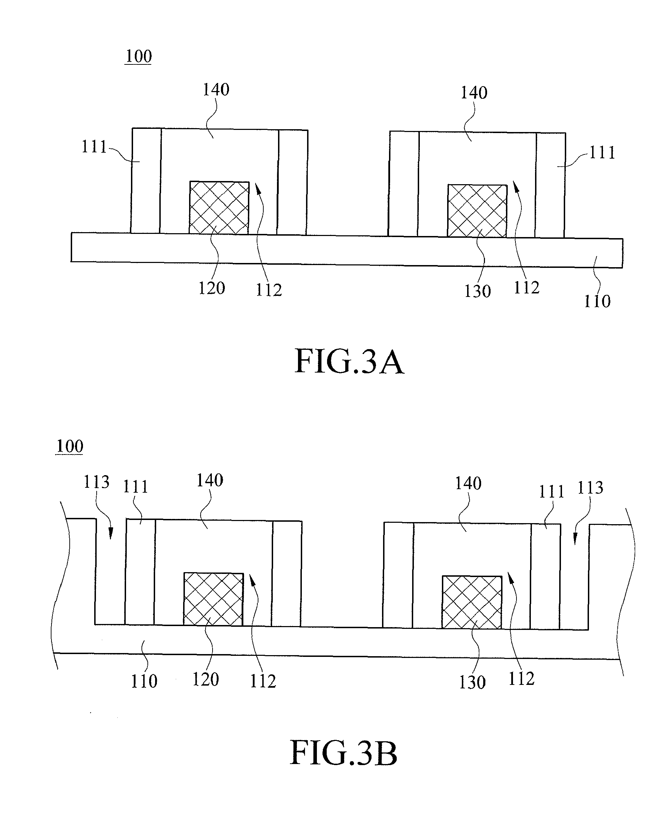

FIG. 3A is a cross-sectional side view of a third embodiment of the present invention. As shown in FIG. 3A, an LED package structure 100 according to the third embodiment of the present invention comprises a substrate 110, at least one first LED 120, at least one second LED 130, and a resin material 140. A material of the substrate 110 is selected from a group consisting of, but not limited to, a metal material, a ceramic material, a diamond material, a diamond-like carbon material, and a printed circuit board. Two neighboring enclosures 111 form on a top surface of the substrate 110, and enclose and form two separate areas 112 on the surface of the substrate 110. A material of the enclosures 111 of the present invention is a transparent material, and persons skilled in the art may design the areas 112 into various geometrical shapes according to practical application requirements.

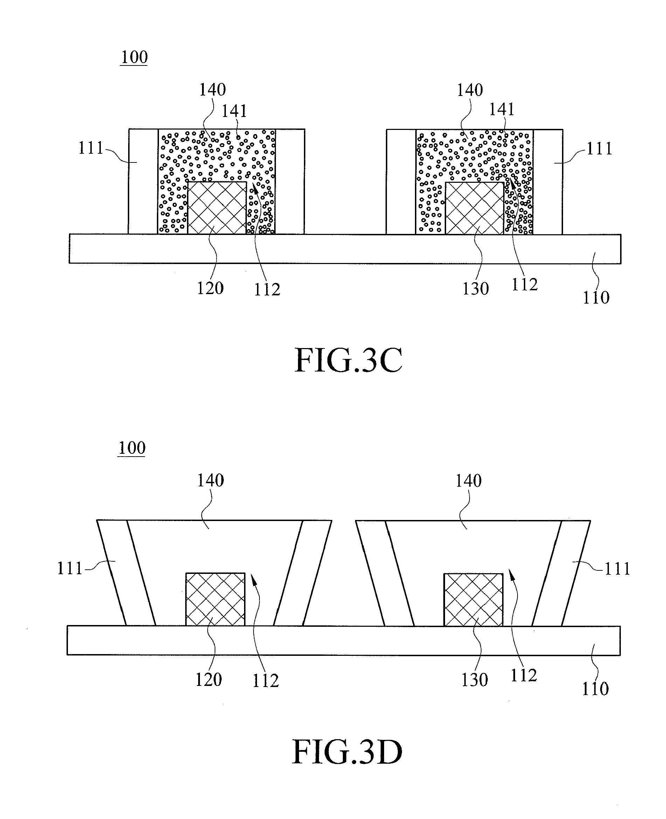

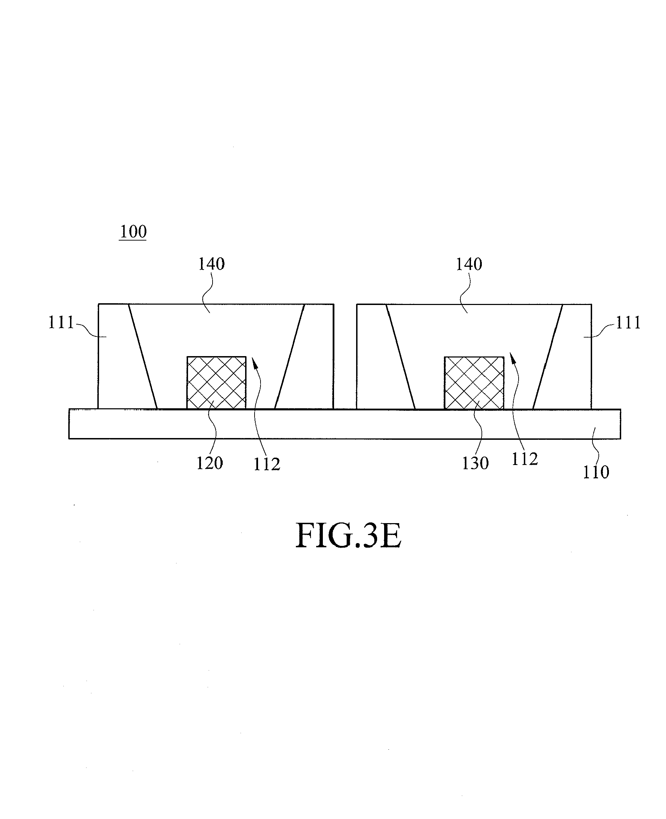

In addition, the enclosures 111 of the third embodiment shown in FIG. 3A have a rectangular plate-like structure, and the enclosures 111 are perpendicular to the substrate 110. However, the enclosures 111 of the present invention may also be designed as being disposed on the substrate 110 at an angle of inclination as shown in FIG. 3D, or designed into a trapezoid-like structure as shown in FIG. 3E, which both aim at optimizing light reflection. Therefore, persons skilled in the art may further derive and design various geometrical shapes and different placement angles for the enclosures 111 of the present invention according to practical application requirements, which are not limited to the embodiments of the present invention.

Still referring to FIG. 3A, the first LED 120 is disposed in one of the areas 112, and the second LED 130 is disposed in the other area 112, that is, the two LEDs 120 and 130 are located in the enclosures 111. The first LED 120 and the second LED 130 are electrically connected to a voltage respectively, and the first LED 120 and the second LED 130 are driven by the voltage to respectively emit a first light with a first wavelength and a second light with a second wavelength.

It should be noted that, a wavelength range of the first wavelength of the first LED 120 may be identical to a wavelength range of the second wavelength of the second LED 130, that is, the lights emitted by the first LED 120 and the second LED 130 are of the same color. Therefore, an illuminating light obtained by mixing the first light with the second light is of the same color as the first light and the second light, for example, various light colors such as cold white light, warm white light, and sunlight-like white light are obtained. The illuminating light has high color rendering properties. The lights emitted by the two LEDs 120 and 130 may be short-wavelength light with a wavelength range of 360 nm to 550 nm, or may be long-wavelength light with a wavelength range of 580 nm to 640 nm. Alternatively, the wavelength range of the first wavelength of the first LED 120 may be different from the wavelength range of the second wavelength of the second LED 130, that is, the lights emitted by the first LED 120 and the second LED 130 are of different colors. Therefore, the illuminating light obtained by mixing the first light with the second light is of a color corresponding to the actual colors of the first light and the second light, for example, various light colors such as cold white light, warm white light, and sunlight-like white light are obtained. The illuminating light has high color rendering properties. The light emitted by one of the LEDs 120 and 130 may be short-wavelength light with a wavelength range of 360 nm to 550 nm, and the light emitted by the other one of the LEDs 120 and 130 may be long-wavelength light with a wavelength range of 580 nm to 640 nm. The illuminating light of the present invention has a total reflection effect of vertical and horizontal reflection by using the enclosures 111, thereby avoiding excessively high light loss of the illuminating light in the refraction process.

The number of the first LED 120 and the second LED 130 arranged in this embodiment may be increased or decreased according to practical application requirements, as long as the LEDs in the same area 112 have the same wavelength range.

A material of the resin material 140 of the present invention may be, but not limited to, a polymer material such as epoxy resin or silicone. The resin material 140 is filled in the two areas 112, and completely covers the first LED 120 and the second LED 130, thereby forming a complete LED package structure 100.

FIG. 3B is a cross-sectional side view of a different aspect of the third embodiment of the present invention. As shown in FIG. 3B, the LED package structure 100 comprises a substrate 110, at least one first LED 120, at least one second LED 130, and a resin material 140. The substrate 110 further has a groove 113 recessed therein. Two enclosures 111 are disposed in the groove 113. The first LED 120 and the second LED 130 are disposed in the enclosures 111, so that the first LED 120 and the second LED 130 are also electrically disposed in the groove 113. The resin material 140 is filled in the two areas 112, and completely covers the first LED 120 and the second LED 130, thereby forming a complete LED package structure 100. When an illuminating light is reflected to a wall surface of the groove 113, the groove 113 provides a preferable light reflection effect.

FIG. 3C is a cross-sectional side view of a different aspect of the third embodiment of the present invention. As shown in FIG. 3C, the LED package structure 100 comprises a substrate 110, at least one first LED 120, at least one second LED 130, and a resin material 140. Two neighboring enclosures 111 form on a top surface of the substrate 110, and enclose and form two separate areas 112 on the surface of the substrate 110. The enclosures 111 are made of a transparent material. The first LED 120 and the second LED 130 are respectively disposed in the two areas 112, that is, the two LEDs 120 and 130 are located in the enclosures 111. The first LED 120 and the second LED 130 are driven by a voltage to respectively emit a first light with a first wavelength and a second light with a second wavelength.

The resin material 140 is filled in the two areas 112, and completely covers the first LED 120 and the second LED 130, thereby forming a complete LED package structure 100. The resin material 140 may further contain a fluorescent material 141 in a powder form. The fluorescent material 141 is selected from a group consisting of Sr_{1-x-y}BaₓCa_{y}SiO₄:Eu₂₊F, (Sr_{1-x-y}EuₓMn_{y})P_{2+z}O₇ :E_{U2+}F, (Ba,Sr,Ca)Al₂O₄:Eu, ((Ba,Sr,Ca)(Mg,Zn))Si₂O₇:Eu, SrGa₂S₄:Eu, ((Ba,Sr,Ca)₁₋ₓEuₓ)(Mg,Zn)₁₋ₓMnₓ))Al₁₀O₁₇, Ca₈Mg(SiO₄)₄Cl₂:Eu,Mn, ((Ba,Sr,Ca,Mg)₁₋ₓEuₓ)₂SiO₄, Ca₂MgSi₂O₇:Cl, SrSi₃O₈·2SrCl₂:Eu, BAM:Eu, Sr-Aluminate:Eu, Thiogallate:Eu, Chlorosilicate:Eu, Borate:Ce,Tb, Sr₄Al₁₄O₂₅:Eu, YBO₃:Ce,Tb, BaMgAl₁₀O₁₇:Eu,Mn, (Sr,Ca,Ba)(Al,Ga)₂S₄:Eu, Ca₂MgSi₂O₇:Cl,Eu,Mn, (Sr,Ca,Ba,Mg)₁₀(P0₄)₆CI₂:Eu ZnS:Cu,Al, (Y,Gd,Tb,Lu,Yb)(Al_{y}Ga_{1-y})₅O₁₂:Ce, (Sr_{1-x-y-z}BaₓCa_{y}Eu_{z})₂SiO₄, (Sr_{1-a-b}Ca_{b}Ba_{c})SiₓN_{y}O_{z}:Euₐ Sr₅(PO₄)₃Cl:Euₐ, and any combination thereof. However, the fluorescent material 141 is not limited to the above materials, and the form of the fluorescent material 141 is not limited to the powder form disclosed in this embodiment as well, and persons skilled in the art may add the fluorescent material 141 into the resin material 140 in various forms according to practical fabrication requirements, for example, adhere the fluorescent material 141 to a top surface of the resin material 140 in a colloid form. When an illuminating light passes through the resin material 140, the fluorescent material 141 mixed in the resin material 140 provides a preferable reflection effect for the illuminating light.

In the present invention, at least one area is formed on the substrate by using the enclosure, at least two LEDs (that is, the first LED and the second LED) are disposed in the area, and an illuminating light of a desired color such as cold white light, warm white light, sunlight-like white light, and various other color light can be obtained by mixing the lights emitted by the LEDs.

In addition, the present invention adopts a technical means of using the light-transmissive enclosure to enclose the LEDs, so that the LED package structure of the present invention is quite simple, so that the manufacturing steps are greatly simplified and the manufacturing cost are dramatically reduced, and meanwhile, the luminous efficiency of the LED package structure is improved.

## Claims

1. A light-emitting diode (LED) package structure, comprising:
a substrate having an enclosure disposed on a surface thereof, wherein the enclosure encloses and forms an area on the substrate, and a material of the enclosure is a transparent material;
a first LED disposed in the area for emitting a first light with a first wavelength;
a second LED disposed in the area and adjacent to the first LED for emitting a second light with a second wavelength, wherein the second light is mixed with the first light to obtain an illuminating light; and
a resin material disposed in the area for covering the first LED and the second LED.

2. The LED package structure according to claim 1, wherein the substrate further has a groove recessed therein, and the enclosure is disposed in the groove.

3. The LED package structure according to claim 1, wherein the resin material further contains a fluorescent material.

4. The LED package structure according to claim 1, wherein a wavelength range of the first wavelength is identical to a wavelength range of the second wavelength.

5. The LED package structure according to claim 1, wherein a wavelength range of the first wavelength is different from a wavelength range of the second wavelength.

6. A light-emitting diode (LED) package structure, comprising:
a substrate having an enclosure and a partition wall disposed on a surface thereof, wherein the partition wall is disposed in the enclosure so as to enclose and form two areas on the substrate, and a material of the enclosure is a transparent material;
at least one first LED disposed in one of the areas for emitting a first light with a first wavelength;
at least one second LED disposed in the other area for emitting a second light with a second wavelength, wherein the second light is mixed with the first light to obtain an illuminating light; and
a resin material disposed in the areas for covering the first LED and the second LED.

7. The LED package structure according to claim 6, wherein the substrate further has a groove recessed therein, and the enclosure is disposed in the groove.

8. The LED package structure according to claim 6, wherein the resin material further contains a fluorescent material.

9. The LED package structure according to claim 6, wherein a wavelength range of the first wavelength is identical to a wavelength range of the second wavelength.

10. The LED package structure according to claim 6, wherein a wavelength range of the first wavelength is different from a wavelength range of the second wavelength.

11. A light-emitting diode (LED) package structure, comprising:
a substrate having two neighboring enclosures disposed on a surface thereof, wherein the two enclosures enclose and form two areas on the substrate, and a material of the two enclosures is a transparent material;
at least one first LED disposed in one of the areas for emitting a first light with a first wavelength;
at least one second LED disposed in the other area for emitting a second light with a second wavelength, wherein the second light is mixed with the first light to obtain an illuminating light; and
a resin material disposed in the two areas for covering the first LED and the second LED.

12. The LED package structure according to claim 11, wherein the substrate further has a groove recessed therein, and the enclosures are disposed in the groove.

13. The LED package structure according to claim 11, wherein the resin material further contains a fluorescent material.

14. The LED package structure according to claim 11, wherein a wavelength range of the first wavelength is identical to a wavelength range of the second wavelength.

15. The LED package structure according to claim 11, wherein a wavelength range of the first wavelength is different from a wavelength range of the second wavelength.
